# EUROPÄISCHE PATENTSCHRIFT

(11) **EP 1 715 582 B1**
(45) Veröffentlichungstag und Bekanntmachung des Hinweises auf die Patenterteilung: **03.11.2010**
(21) Anmeldenummer: 05103276.1
(22) Anmeldetag: 22.04.2005
(51) Int. Cl.: H03K 17/06, H02M 3/155

(54) **Schaltungsanordnung zur Ansteuerung eines elektrischen Leistungsschalters auf hohem Spannungspotenzial**
Circuit arrangement for driving an electric power switch at high voltage
Agencement de circuit destiné à piloter un commutateur de puissance électrique à haute tension

(43) Veröffentlichungstag der Anmeldung: 25.10.2006
(73) Patentinhaber: ebm-papst Mulfingen GmbH & Co. KG, 74673 Mulfingen (DE)
(72) Erfinder: Krotsch, Jens, 97996, Niederstetten (DE)
(74) Vertreter: Patentanwälte Dr. Solf & Zapf

(56) Entgegenhaltungen:
- WO-A-2005/027327
- US-A- 5 352 932
- US-A1- 2004 012 411

## Beschreibung

Die Erfindung betrifft eine elektrische Schaltungsanordnung zur Ansteuerung von schaltenden Leistungshalbleiterbauelementen auf hohem Spannungspotenzial mit einem eine Schaltinformation für das Leistungshalbleiterbauelement vorgebenden Stellsignal und einer das Leistungshalbleiterbauelement unmittelbar steuernden Ausgangsspannung, wobei ein nicht steuerbares Halbleiterventil zur Übertragung einer Schaltenergie dient, wobei das nicht steuerbare Halbleiterventil als Bauelement mit hoher Spannungsfestigkeit zur Übertragung der Schaltinformation ausgeführt ist.

Die Leistungsstellung von elektrischen Verbrauchern, wie z. B. von elektrischen Motoren, erfolgt durch Stromrichterschaltungen, die ein oder mehrere steuerbare oder nicht steuerbare Leistungshalbleiterbauelemente, wie z. B. Leistungshalbleiterventile, aufweisen. Steuerbare Leistungshalbleiterventile sind Transistoren und Thyristoren, nicht steuerbar ist die Diode. Der Schaltzustand steuerbarer Halbleiterventile wird in Abhängigkeit von Eingangssignalen, insbesondere Leistungsstellsignal, Drehzahl oder Rotorlage eines Motors, von einer Steuerung oder Regelung vorgegeben. Die Steuerung oder Regelung stellt die Schaltinformation in Form logischer Signale bereit, die von Treiberschaltungen auf die zur Ansteuerung der Leistungshalbleiterbauelemente erforderlichen Pegel und Potenziale umgesetzt werden.

Bei elektrischen Verbrauchern, die hohe Versorgungsspannungen benötigen, z. B. an Einphasen- oder Dreiphasenwechselspannungsnetze angeschlossene Maschinen, müssen Halbleiterbauelemente mit hoher Spannungsfestigkeit verwendet werden. Diese sind nur mit großem Aufwand als integrierte Schaltkreise realisierbar. Die Kosten für die Treiberschaltung stellen einen erheblichen Anteil an den Gesamtkosten eines Leistungsstellers dar.

Aus dem Stand der Technik sind Schaltungsanordnungen bekannt, in denen ein Leistungstransistor als steuerbares Halbleiterbauelement den über seine Kollektor-Emitter-Strecke zu einem Verbraucher fließenden Laststrom und damit die dem Verbraucher zugeführte elektrische Leistung bestimmt. Über eine Treiberstufe wird eine Gate-Emitter-Spannung vorbestimmter Höhe erzeugt, die im Schaltbetrieb die Kollektor-Emitter-Strecke des Transistors in den leitenden Zustand versetzt. Die Stromversorgung der Treiberstufe geschieht dabei unabhängig vom Schaltzustand des Transistors über einen Kondensator, der über ein nicht steuerbares Halbleiterventil, eine Diode, auf die Betriebsspannung einer Spannungsquelle aufgeladen wird. Zur Leistungsstellung des Verbrauchers wird in einem Steuerungsteil als Schaltinformation ein Stellsignal A vorgegeben, das als Eingangssignal der Treiberstufe dient. Da die Treiberstufe an das hohe Emitterpotenzial des Leistungstransistors angekoppelt ist, muss das Stellsignal A durch einen Pegelumsetzer auf dieses Spannungspotenzial transferiert werden. Eine solche Schaltungsanordnung wird auch als Bootstrap-Schaltung bezeichnet.

Die Realisierung einer solchen dem Stand der Technik entsprechenden Schaltungsanordnung findet sich in dem Treiberbaustein IR2106 der Firma International Rectifier (Datenblatt IR2106, April 1999). Hier werden zur Pegelumsetzung der Schaltinformation hochspannungsfeste Transistoren verwendet.

Nachteilig bei dem gezeigten Stand der Technik ist, dass sowohl die Halbleiterbauelemente, über die der Kondensator die Schaltenergie für den Leistungsschalter bereitstellt, als auch der Pegelumsetzer, über den die Schaltinformation übertragen wird, eine hohe Spannungsfestigkeit aufweisen müssen. Insbesondere die Realisierung des Pegelumsetzers ist mit großem Kostenaufwand verbunden.

Aus der US-A-5,352,932 ist eine gattungsgemäße Schaltungsanordnung bekannt. Hierbei wird von der Ansteuerschaltung ein Leistungs-Feldeffekttransistor angesteuert, an dessen Source-Elektrode eine Last betrieben wird. Offenbart ist eine Diode in Reihe mit einem Kondensator. Die Diode überträgt sowohl die von dem Kondensator gespeicherte Schaltenergie als auch die durch den Schalter vorgegebene Schaltinformation. Jedoch werden die Schaltenergie und die Schaltinformation auf verschiedenen Signalpfaden übertragen und repräsentieren damit auch zwei physikalisch verschiedene Signale.

Der vorliegenden Erfindung liegt die Aufgabe zu Grunde, eine Schaltungsanordnung der eingangs beschriebenen Art zur Verfügung zu stellen, die mit einer gegenüber dem

Stand der Technik geringeren Anzahl von Bauelementen mit hoher Spannungsfestigkeit auskommt und kostengünstig ausführbar ist.

Diese Aufgabe wird erfindungsgemäß dadurch gelöst, dass das Stellsignal den Verlauf einer Ausgangsspannung einer steuerbaren Spannungsquelle bestimmt, die mit dem in Durchlassrichtung gepolten nicht steuerbaren Halbleiterventil und einem Kondensator, insbesondere einer Kondensatoranordnung, in Reihe geschaltet ist.

Die erfindungsgemäße Anordnung ermöglicht die Ansteuerung eines auf hohem Spannungspotenzial liegenden schaltenden Leistungshalbleiters mit nur einem nicht steuerbaren Halbleiterventil, d. h. einer Diode, als spannungsfestem Bauelement, somit kann auf einen kostspielig zu realisierenden Pegelumsetzer verzichtet werden, da das nicht steuerbare Halbleiterventil nicht nur zur Energieübertragung verwendet wird, wie es bei der bekannten Bootstrap-Schaltung der Fall ist, sondern gleichzeitig auch zur Übermittlung des gewünschten Schaltzustandes des Leistungstransistors auf das hohe Spannungspotenzial. Als besonderer Vorteil resultiert daraus ein deutlich geringerer Kostenaufwand, da ein Pegelumsetzer mindestens ein weiteres spannungsfestes und damit teures, steuerbares Halbleiterbauelement voraussetzen würde. Als Eingangssignal der erfindungsgemäßen Schaltungsanordnung bestimmt das Stellsignal den Verlauf einer Ausgangsspannung einer steuerbaren Spannungsquelle, die mit dem in Durchlassrichtung gepolten nicht steuerbaren Halbleiterventil und einem Kondensator in Reihe geschaltet ist. Vorteilhafterweise können durch dieses Stellsignal die Signalparameter, insbesondere Größe, Frequenz und Tastverhältnis, der Ausgangsspannung der steuerbaren Spannungsquelle so vorgegeben werden, dass sich eine kontinuierliche Veränderung der Leistungsaufnahme des Verbrauchers ergibt.

Eine vorteilhafte Ausgestaltung sieht vor, dass ein Schaltungsteil parallel zu dem Kondensator geschaltet ist und von einer sich über dem Kondensator einstellenden Spannung versorgt wird, die die Schaltinformation und die Schaltenergie speichert.

Durch diese schaltungstechnische Verknüpfung, d. h. den Signalpfad über das nicht steuerbare Halbleiterventil, von zwei funktional verschiedenen Aufgaben, hier die Energieversorgung und die Informationsübertragung, entfällt die Notwendigkeit einer kostspieligen Pegelumsetzung.

In Erweiterung dieser Ausgestaltung ist parallel zu dem Kondensator eine Reihenschaltung eines zweiten Kondensators und einem zweiten nicht steuerbarem Halbleiterventil, d. h. einer Diode, allerdings mit nur geringer Spannungsfestigkeit, vorgesehen. Durch diese schaltungstechnische Maßnahme kann der zweite Kondensator die Aufgabe der Energieversorgung übernehmen, während ersterer die Schaltinformation speichert und die Diode beide Funktionen entkoppelt. Auf diese Weise kann ein nachgeschaltetes Schaltungsteil über einen größeren Bereich angesteuert werden.

Von besonderem Vorteil ist, dass der Schaltungsteil eine Ausgangsspannung zur Ansteuerung des Leistungshalbleiterbauelements als Funktion der eingangsseitig anliegenden Kondensatorspannung erzeugt. Dabei ist die erzeugte Ausgangsspannung ausschließlich von der am Eingang des Schaltungsteils anliegenden Kondensatorspannung abhängig. Da diese Kondensatorspannung neben der Schaltenergie erfindungsgemäß auch die Information des Schaltzustands übermittelt, entfällt die aufwändige Transformation der Schaltinformation auf hohe Spannungspegel über einen Pegelumsetzer.

Weitere zweckmäßige Ausgestaltungen sind den Unteransprüchen zu entnehmen.

Anhand des in den beiliegenden Zeichnungen dargestellten Ausführungsbeispiels wird die Erfindung näher erläutert. Es zeigen:
- Fig. 1: ein Anwendungsbeispiel einer erfindungsgemäßen Schaltungs- anordnung,
- Fig.2: eine Eingangs-Ausgangsspannungs-Kennlinie eines Schaltungsteils gemäß der Erfindung,
- Fig. 3: ein dynamisches Verhalten des Schaltungsteils gemäß der Erfindung,
- Fig. 4: Spannungsverläufe einer Ausgangsspannung einer gesteuerten Spannungsquelle, einer Kondensatorspannung, einer Ausgangsspannung des Schaltungsteils und einer an einem Verbraucher liegenden Spannung bei Vorgabe eines Rechteck-Impulses,
- Fig. 5: Spannungsverläufe der Ausgangsspannung der gesteuerten Spannungsquelle, der Kondensatorspannung, der Ausgangsspannung des Schaltungsteils und der an dem Verbraucher liegenden Spannung bei Vorgabe einer periodischen Rechteck-Impulsfolge,
- Fig. 6: Spannungsverläufe der Ausgangsspannung der gesteuerten Spannungsquelle, der Kondensatorspannung, der Ausgangsspannung des Schaltungsteils und der an dem Verbraucher liegenden Spannung bei Vorgabe der periodischen Rechteck-Impulsfolge mit veränderter Amplitude gegenüber Fig. 5,
- Fig. 7: ein weiteres Ausführungsbeispiel der erfindungsgemäßen Schaltungsanordnung.

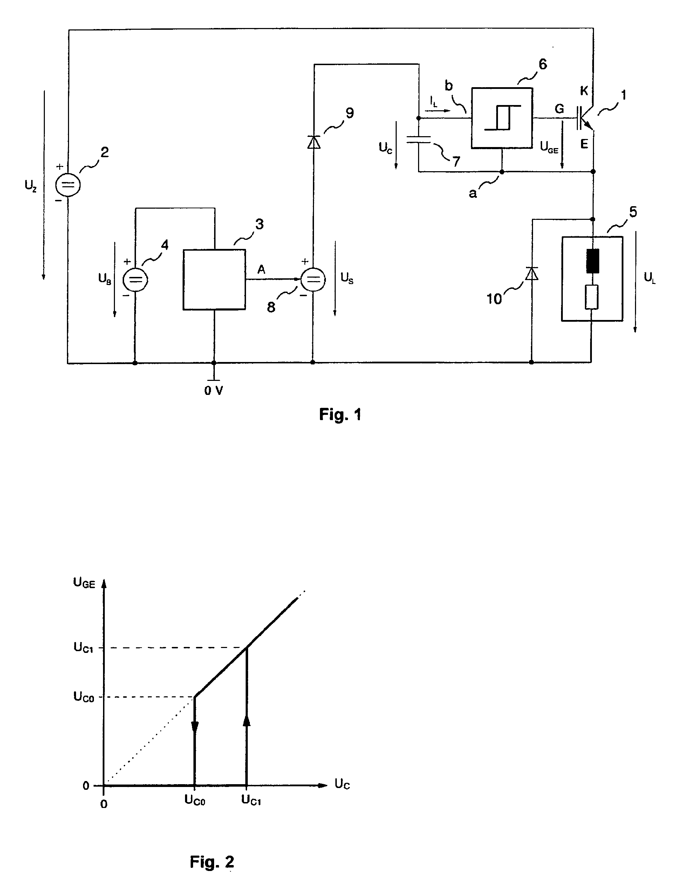

Fig.1 zeigt ein Anwendungsbeispiel der erfindungsgemäßen Schaltungsanordnung mit äußerer Beschaltung. Die erfindungsgemäße Schaltungsanordnung setzt sich aus einem Schaltungsteil 6, einem Kondensator 7, einer steuerbaren Spannungsquelle 8 und einem nicht steuerbaren Halbleiterventil 9, d. h. einer Diode, zusammen. Die äußere Beschaltung umfasst ein steuerbares Leistungshalbleiterbauelement 1 mit seinem Kollektor K, einem Gate G und einem Emitter E, eine Gleichspannungsquelle 2, ein Steuerungsteil 3, das von einer Spannungsquelle 4 versorgt wird und einen Verbraucher 5 mit Freilaufdiode 10.

Das Leistungshalbleiterbauelement 1 ist mit seinem Kollektor K mit einem positiven Anschluss der Gleichspannungsquelle 2 verbunden. Der Emitter E des Leistungshalbleiterbauelements 1 ist mit dem Verbraucher 5 verbunden und dieser mit einem negativen Anschluß der Gleichspannungsquelle 2. Die parallel zu dem Verbraucher 5 geschaltete Freilaufdiode 10 übernimmt mögliche induktive Freilaufströme. Um das Leistungshalbleiterbauelement 1 in den leitenden Zustand zu versetzen, muss eine positive Gate-Emitterspannung U_{GE} vorbestimmter Höhe angelegt werden. Dies übernimmt der Schaltungsteil 6, der an den Anschlusspunkten a, b über den Kondensator 7 versorgt wird. Die steuerbare Spannungsquelle 8, deren Ausgangsspannung U_{S} durch ein Stellsignal A des Steuerungsteils 3 bestimmt wird, ist über das in Durchlassrichtung gepolte nicht steuerbare Halbleiterventil 9 mit dem Kondensator 7 in Reihenschaltung verbunden.

Im Gegensatz zu einer Treiberstufe, wie sie dem Stand der Technik gemäß anstelle des Schaltungsteils 6 verwendet wird, weist der Schaltungsteil 6 in dieser Ausführung keinen separaten Eingang zur Vorgabe des gewünschten Schaltzustandes des Leistungshalbleiterbauelements 1 auf. Der Schaltzustand hängt ausschließlich von einer über dem Kondensator 7 auftretenden Spannung U_{C} ab, deren Verlauf wiederum von der mittels Stellsignal A einstellbaren Ausgangsspannung U_{S} der steuerbaren Spannungsquelle 8 abhängt.

In dieser Anordnung wird das nicht steuerbare Halbleiterventil 9 nicht nur zur Übertragung der Schaltenergie für das Leistungshalbleiterbauelement 1 verwendet, sondern gleichzeitig auch zur Übermittlung des gewünschten Schaltzustandes des Leistungshalbleiterbauelements 1. Zur Übertragung der Schaltenergie und der Schaltinformation ist das nicht steuerbare Halbleiterventil 9 damit das einzige erforderliche Halbleiterbauelement mit hoher Spannungsfestigkeit.

Fig. 2 zeigt die Eingangs-Ausgangsspannungs-Kennlinie des Schaltungsteils 6. Dargestellt ist die Ausgangsspannung U_{GE} des Schaltungsteils 6 als statische Funktion der am Schaltungsteil 6 anliegenden Kondensatorspannung U_{C}. ist die Kondensatorspannung U_{C} größer als ein vordefinierter oberer Spannungsgrenzwert U_{C1}, dann wird eine Ausgangsspannung U_{GE} erzeugt, die größer oder gleich der Kondensatorspannung U_{C} ist. Ist die Kondensatorspannung U_{C} kleiner als ein vordefinierter unterer Spannungsgrenzwert U_{C0}, der stets kleiner ist als U_{C1}, dann wird eine Ausgangsspannung U_{GE} erzeugt, die kleiner oder gleich der Kondensatorspannung U_{C} ist. Die Grenzwerte U_{C0} und U_{C1} werden hierbei abhängig vom spezifischen Schaltverhalten des Leistungshalbleiterbauelements 1 im Voraus so festgelegt, dass eine Kondensatorspannung U_{C} > U_{C1} zu einem sicheren Leiten des Leistungshalbleiterbauelements 1 und eine Kondensatorspannung U_{C} < U_{C0} zu einem sicheren Sperren des Leistungshalbleiterbauelements 1 führt.

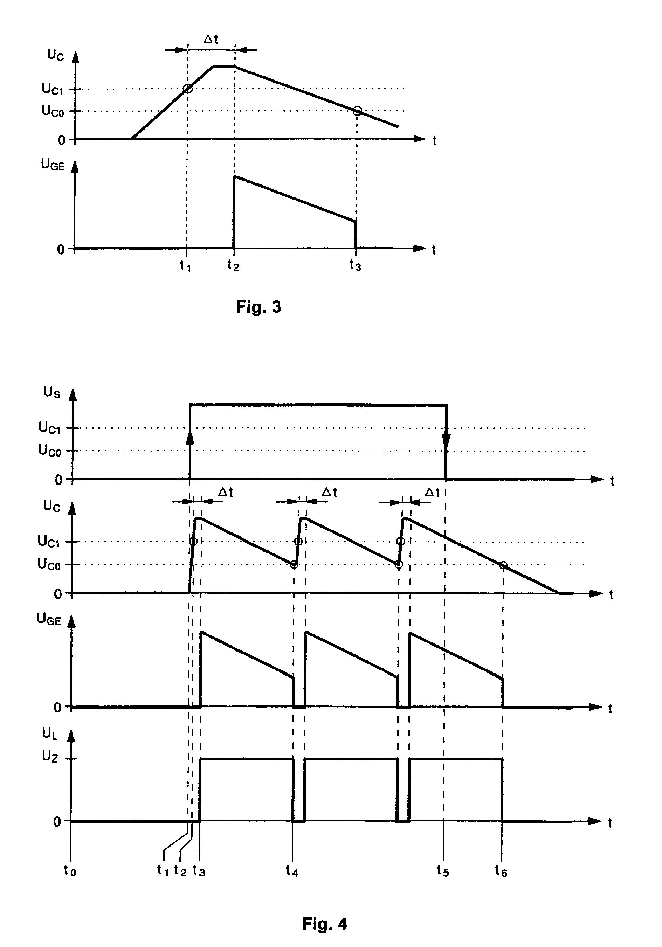

Fig. 3 verdeutlicht das dynamische Verhalten des Schaltungsteils 6. Die eingangsseitige Kondensatorspannung U_{C} und die Ausgangsspannung U_{GE} sind über der Zeit dargestellt. Zum Zeitpunkt t₁ übersteigt die Spannung U_{C} den vordefinierten oberen Spannungsgrenzwert U_{C1}. Daraufhin erzeugt der Schaltungsteil 6 nach einer festgelegten Verzögerung Δt zum Zeitpunkt t₂ eine Ausgangsspannung U_{GE}, die entsprechend der in Fig. 2 beschriebenen Kennlinie mindestens die Größe der Kondensatorspannung U_{C} besitzt. Zum Zeitpunkt t₃ unterschreitet U_{C} im beispielhaften Verlauf den unteren Spannungsgrenzwert U_{C0}, worauf der Schaltungsteil 6 ohne Verzögerung eine möglichst kleine Ausgangsspannung U_{GE} - hier ist der Wert Null gemäß Kennlinie dargestellt - erzeugt.

Gemäß Fig. 1 liegt bei leitendem Leistungshalbleiterbauelement 1 nahezu die gesamte Spannung U_{Z} der Gleichspannungsquelle 2 über dem Verbraucher 5 an, das nicht steuerbare Halbleiterventil 9 sperrt. Der Kondensator 7 entlädt sich, z. B. über den Eigenstromverbrauch I_{L} des Schaltungsteils 6 oder aber über eine speziell dafür vorgesehenen Entladewiderstand oder eine Entladestromquelle, zur Vereinfachung der Fig. 1 nicht dargestellt. Wird die Kondensatorspannung U_{C} infolge der Entladung kleiner als der untere Spannungsgrenzwert U_{C0}, sperrt das Leistungshalbleiterbauelement 1. Die Einschaltdauer des Leistungshalbleiterbauelements 1 kann somit über die Höhe der Kondensatorspannung U_{C} vorgegeben werden.

Zur Vorgabe der Kondensatorspannung U_{C} ist eine steuerbare Spannungsquelle 8 vorgesehen, die mit ihrem negativen Anschluss ebenfalls mit dem Bezugspotenzial 0 V verbunden ist und deren Spannung U_{S} nach Größe, Frequenz und Tastverhältnis von dem Steuerungsteil 3 bestimmt wird. Sperrt nun das Leistungshalbleiterbauelement 1, ist der Emitteranschluss E des Leistungshalbleiterbauelements 1 und damit der nicht mit dem nicht steuerbaren Halbleiterventil 9 verbundene Anschluß des Kondensators 7 über den Verbraucher 5 niederohmig mit dem Bezugspotenzial 0 V verbunden. Das nicht steuerbare Halbleiterventil 9 wird leitend und der Kondensator lädt sich schlagartig auf die Spannung U_{S} auf. Ist U_{C} > U_{C1}, wird das Leistungshalbleiterbauelement 1 leitend und verbleibt solange im leitfähigen Zustand, bis die Kondensatorspannung U_{C} < U_{C0} wird. Der Entladestrom I_{L} wird hierbei stets so festgelegt, dass der Entladevorgang wesentlich langsamer erfolgt als der Ladevorgang über das nicht steuerbare Halbleiterventil 9, d. h. die Ladezeitdauer ist z. B. 1/20 der Entladezeit.

Die Fig. 4 zeigt bei Vorgabe eines Rechteck-Impulses mit den Spannungswerten U_{S} = 0 V und U_{S} > U_{C1} als Spannungsverlauf U_{S} der gesteuerten Spannungsquelle 8 für die erfindungsgemäße Schaltungsanordnung nach Fig. 1 beispielhaft die Spannungsverläufe der Kondensatorspannung U_{C}, der Ausgangsspannung U_{GE} des Schaltungsteils 6, die der Steuerspannung des Leistungshalbleiterbauelements 1 entspricht, und die an dem Verbraucher liegende Spannung U_{L}.

Ausgehend von einem ungeladenen Kondensator 7 und sperrendem Leistungshalbleiterbauelement 1 ist der Verbraucher 5 zum Zeitpunkt t₀ zunächst stromlos. Zum Zeitpunkt t₁ erzeugt der Steuerungsteil 3 ein Stellsignal A, das zu einem Sprung der Spannung U_{S} über der steuerbaren Spannungsquelle 8 auf einen Wert führt, der größer ist als der obere Spannungsgrenzwert U_{C1} ist. Der Kondensator 7 lädt sich über das nicht steuerbare Halbleiterventil 9 und den Verbraucher 5 auf die Spannung U_{S} auf. Zum Zeitpunkt t₂ übersteigt Kondensatorspannung U_{C} den oberen Spannungsgrenzwert U_{C1}. Da U_{C} > U_{C1}, erzeugt der Schaltungsteil 6 gemäß seiner in Fig. 2 dargestellten Kennlinie nach einer vordefinierten Verzögerung Δt zum Zeitpunkt t₃ eine positive Ausgangsspannung U_{GE}. Das Leistungshalbleiterbauelement 1 wird dadurch leitend, die Spannung U_{L} am Verbraucher 5 beträgt nun nahezu U_{Z}. Dadurch sperrt das nicht steuerbare Halbleiterventil 9 und der Kondensator 7 entlädt sich langsam durch den Strom I_{L}. Unterschreitet die Kondensatorspannung U_{C} den unteren Spannungsgrenzwert U_{C0}, wie es zum Zeitpunkt t₄ der Fall ist, dann wird die Ausgangsspannung U_{GE} des Schaltungsteils 6 unmittelbar auf einen kleinen Wert gezwungen, der zum Sperren des Leistungshalbleiterbauelements 1 führt. Dadurch ist der Emitteranschluß E des Leistungshalbleiterbauelements 1 niederohmig über den Verbraucher 5 mit dem Bezugspotenzial 0 V verbunden. Der Kondensator 7 lädt sich schlagartig über das nicht steuerbare Halbleiterventil 9 auf die Spannung U_{S} auf, was wiederum zum Einschalten des Leistungshalbleiterbauelements 1 führt. Dieser Vorgang wiederholt sich solange die Spannung U_{S} > U_{C1} ist. Zum Zeitpunkt t₅ bewirkt der Steuerungsteil 3 über das Stellsignal A ein Absinken der Spannung U_{S} über der steuerbaren Spannungsquelle 8 auf einen Wert kleiner als U_{C0}, insbesondere gleich Null, wodurch das Leistungshalbleiterbauelement 1 nach dem Abschalten zum Zeitpunkt t₆ im sperrenden Zustand verbleibt.

Der Verbraucher 5 kann also wie beschrieben, abhängig vom Stellsignal A an Spannung gelegt, oder von ihr getrennt werden. Im Gegensatz zum Stand der Technik ist jedoch bei der Erfindung kein Pegelumsetzer mit hoher Spannungsfestigkeit zum Ansteuern des Leistungshalbleiterbauelements 1 erforderlich.

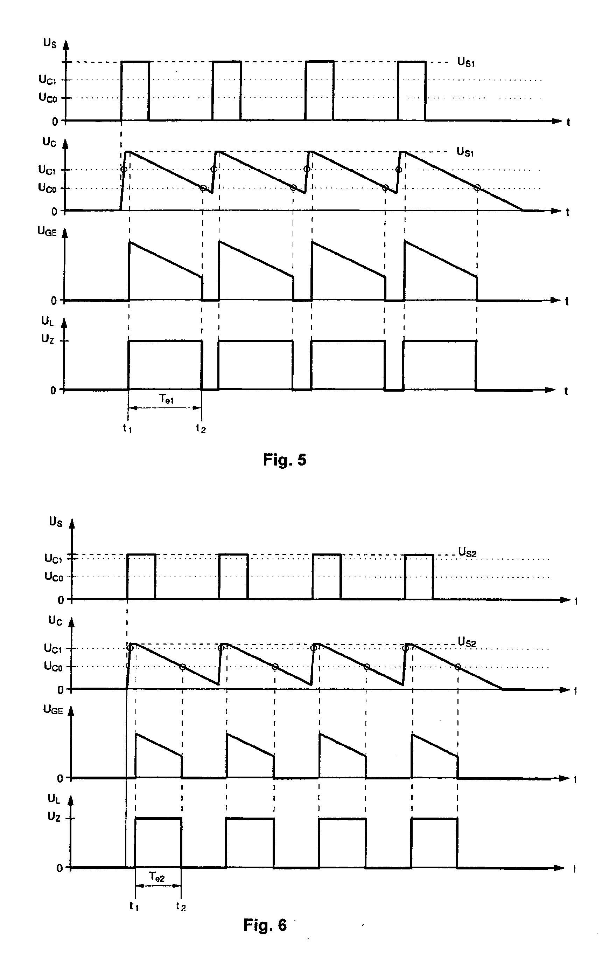

In einer weiteren vorteilhaften Ausgestaltung der Erfindung ist vorgesehen, die Leistung des Verbrauchers kontinuierlich durch Pulsweitenmodulation der Spannung U_{S} der steuerbaren Spannungsquelle 8 zu verstellen. Hierzu wird das Stellsignal A so von dem Steuerungsteil 3 vorgegeben, dass ein rechteckförmiger periodischer Verlauf der Spannung U_{S} über der steuerbaren Spannungsquelle 8 entsteht. In den Fig. 5 und 6 sind dazu für die erfindungsgemäße Schaltungsanordnung nach Fig.1 beispielhaft die Verläufe der Spannung U_{S} über der steuerbaren Spannungsquelle 8, der Kondensatorspannung U_{C}, der Ausgangsspannung U_{GE} des Schaltungsteils 5 und der an dem Verbraucher 5 liegenden Spannung U_{L} dargestellt.

Fig.5 zeigt eine periodische Rechteck-Impulsfolge mit vordefinierter Frequenz und festgelegtem Tastverhältnis als Spannungsverlauf der gesteuerten Spannungsquelle 8 mit der Spannungsamplitude U_{S1}. Die Entladezeit des Kondensators 7, d. h. die Zeitdauer zwischen t₁ und t₂ bis die Kondensatorspannung U_{C} die Grenze U_{C0} unterschreitet, ist verhältnismäßig lang, die Einschaltzeitdauer Tₑ₁ des Leistungshalbleiterbauelements 1 daher groß. Im Mittel liegt eine große Spannung U_{L} an der Last an. Fig. 6 zeigt dagegen eine periodische Rechteck-Impulsfolge mit gleicher Frequenz und gleichem Tastverhältnis, jedoch mit kleinerer Spannungsamplitude U_{S2}. Die Entladezeit des Kondensators 7, d. h. die Zeitdauer zwischen t₁ und t₂ bis die Kondensatorspannung U_{C} die Grenze U_{C0} unterschreitet, ist verhältnismäßig kurz, die Einschaltzeitdauer Tₑ₂ des Leistungshalbleiterbauelements 1 daher klein. Im Mittel liegt eine kleine Spannung U_{L} an der Last an. Durch Änderung der Amplitude der Spannung U_{S} ist mit der beschriebenen erfindungsgemäßen Schaltungsanordnung die Spannung U_{L} und damit die Leistung des Verbrauchers 5 kontinuierlich veränderbar.

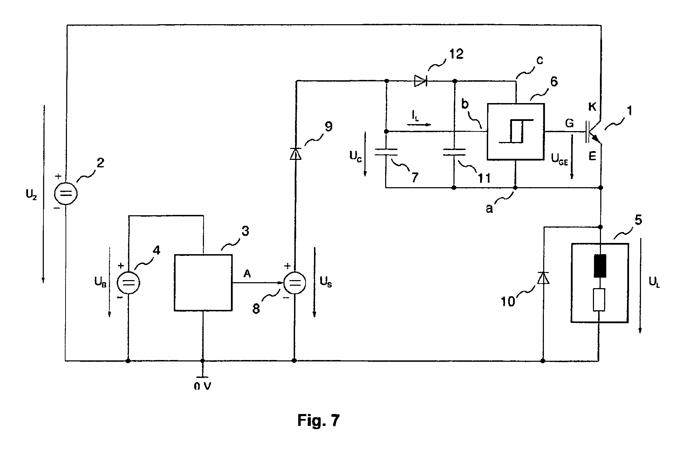

Fig. 7 zeigt ein weiteres Ausführungsbeispiel der erfindungsgemäßen Schaltungsanordnung. Parallel zu dem Kondensator 7 liegt eine Reihenschaltung aus einem zweiten Kondensator 11 mit größerer Kapazität und einem zweiten nicht steuerbaren Halbleiterventil 12 mit nur geringer Spannungsfestigkeit. Der Schaltungsteil 6 weist einen dritten Anschluss c auf, der mit dem zwischen dem zweiten nicht steuerbaren Halbleiterventil 12 und dem zweiten Kondensator 11 liegenden Spannungspotential verbunden ist. Für die zwischen den Anschlusspunkten a, b liegende Kondensatorspannung U_{C} gelten die Gesetzmäßigkeiten der Fig. 2 und 3. In dieser Schaltungsausführung wird die Aufgabe der Energieversorgung von dem Kondensator 11 übernommen. Zur Speicherung der Schaltinformation dient der Kondensator 7 kleinerer Kapazität, und das Halbleiterventil 12 entkoppelt beide Funktionen.

Die Erfindung ist nicht auf die dargestellten und beschriebenen Ausführungsbeispiele beschränkt, sondern umfasst auch alle im Sinne der Erfindung gleichwirkenden Ausführungen.

## Patentansprüche

1. Elektrische Schaltungsanordnung zur Ansteuerung von schaltenden Leistungshalbleiterbauelementen (1) auf hohem Spannungspotenzial mit einem eine Schaltinformation für das Leistungshalbleiterbauelement (1) vorgebenden Stellsignal (A) und einer das Leistungshalbleiterbauelement (1) unmittelbar steuernden Ausgangsspannung (U_{GE}), wobei ein nicht steuerbares Halbleiterventil (9) zur Übertragung einer Schaltenergie dient, wobei das nicht steuerbare Halbleiterventil (9) als Bauelement mit hoher Spannungsfestigkeit zur Übertragung der Schaltinformation ausgeführt ist
**dadurch gekennzeichnet, dass**
das Stellsignal (A) den Verlauf einer Ausgangsspannung (U_{S}) einer steuerbaren Spannungsquelle (8) bestimmt, die mit dem in Durchlassrichtung gepolten nicht steuerbaren Halbleiterventil (9) und einem Kondensator (7), insbesondere einer Kondensatoranordnung (7, 11, 12), in Reihe geschaltet ist...

2. Elektrische Schaltungsanordnung nach Anspruch 1,
**dadurch gekennzeichnet, dass** einSchaltungsteil (6) mit den Anschlusspunkten (a) und (b) parallel zu dem Kondensator (7) geschaltet ist und von einer sich über dem Kondensator (7) einstellenden Spannung (U_{C}) versorgt wird, die die Schaltinformation und die Schaltenergie zur Verfügung stellt.

3. Elektrische Schaltungsanordnung nach Anspruch 1 oder 2,
**dadurch gekennzeichnet, dass** die Kondensatoranordnung (7, 11, 12) aus einer Parallelschaltung des die Schaltinformation speichernden Kondensators (7) mit einer Reihenschaltung eines zweiten die Schaltenergie speichernden Kondensators (11) und einem zweiten nicht steuerbaren Halbleiterventil (12) geringer Spannungsfestigkeit besteht, wobei der Schaltungsteil (6) einen dritten Anschlusspunkt (c) aufweist, der mit dem zwischen dem zweiten nicht steuerbaren Halbleiterventil 12) und dem zweiten Kondensator (11) liegenden Spannungspotential verbunden ist.

4. Elektrische Schaltungsanordnung nach Anspruch 2 oder 3,
**dadurch gekennzeichnet, dass** derSchaltungsteil(6)eine Ausgangsspannung (U_{GE}) zur Ansteuerung des Leistungshalbleiterbauelements (1) als Funktion der eingangsseitig anliegenden Kondensatorspannung (U_{C}) erzeugt.

5. Elektrische Schaltungsanordnung nach einem der Ansprüche 2 bis 4,
**dadurch gekennzeichnet, dass** derSchaltungsteil(6)eine Eingangs-Ausgangsspannungs-Kennlinie besitzt, die eingangsseitig einen unteren Spannungsgrenzwert (U_{C0}) besitzt, unterhalb dessen die Ausgangsspannung (U_{GE}) kleiner gleich der eingangsseitigen Kondensatorspannung (U_{C}), vorzugsweise gleich Null, ist und eingangsseitig einen oberen Spannungsgrenzwert (U_{C1}) besitzt, oberhalb dessen die Ausgangsspannung (U_{GE}) größer gleich, vorzugsweise gleich, der eingangsseitigen Kondensatorspannung (U_{C}) ist.

6. Elektrische Schaltungsanordnung nach Anspruch 5,
**dadurch gekennzeichnet, dass** bei Überschreitung des oberen Spannungsgrenzwerts (U_{C1}) die Ausgangsspannung (U_{GE}) mit einer Zeitverzögerung aufgeschaltet wird.

7. Elektrische Schaltungsanordnung nach einem der Ansprüche 1 bis 6,
**dadurch gekennzeichnet, dass** die steuerbare Spannungsquelle (8) derart ausgebildet ist, dass die Ausgangsspannung (U_{S}) der steuerbaren Spannungsquelle (8) einen rechteckförmigen periodischen Verlauf mit einstellbarer Spannungsamplitude aufweist.

8. Elektrische Schaltungsanordnung nach einem der Ansprüche 1 bis 7,
**dadurch gekennzeichnet, dass** durchdasStellsignal(A)die Amplitude und/oder die Frequenz und/oder das Tastverhältnis der rechteckförmigen periodisch verlaufenden Ausgangsspannung (U_{S}) der steuerbaren Spannungsquelle (8) bestimmt ist.

9. Elektrische Schaltungsanordnung nach einem der Ansprüche 1 bis 8,
**dadurch gekennzeichnet, dass** die Einschaltzeitdauer Tₑ des Leistungshalbleiterbauelements (1) von der Größe der Ausgangsspannung (U_{S}) der steuerbaren Spannungsquelle (8) abhängt, die während des nichtleitenden Zustands des Leistungshalbleiterbauelements (1) an dem Halbleiter-Ventil (9) anliegt.

## Claims

1. Electrical circuit arrangement for driving switching power semiconductor components (1) at high voltage potential, with a control signal (A) predetermining switching information for the power semiconductor component (1) and an output voltage (U_{GE}) directly controlling the power semiconductor component (1), a non-controllable semiconductor gate (9) being used for transferring a switching energy, the non-controllable semiconductor gate (9) being constructed as a component with high dielectric strength for transferring the switching information,
**characterized in that**
the control signal (A) determines the variation of an output voltage (U_{S}) of a controllable voltage source (8) which is connected in series with the non-controllable semiconductor gate (9), polarized in the forward direction, and a capacitor (7), in particular a capacitor arrangement (7, 11, 12).

2. Electrical circuit arrangement according to Claim 1,
**characterized in that** a circuit section (6) is connected in parallel with the capacitor (7) by the connecting points (a) and (b) and is supplied by a voltage (U_{C}) occurring across the capacitor (7) and providing the switching information and the switching energy.

3. Electrical circuit arrangement according to Claim 1 or 2,
**characterised in that** the capacitor arrangement (7, 11, 12) consists of a parallel connection of the capacitor (7) storing the switching information with a series connection of a second capacitor (11) storing the switching energy and a second non-controllable semiconductor gate (12) with low dielectric strength, the circuit section (6) having a third connecting point (c) which is connected to the voltage potential located between the second non-controllable semiconductor gate (12) and the second capacitor (11).

4. Electrical circuit arrangement according to Claim 2 or 3,
**characterized in that** the circuit section (6) generates an output voltage (U_{GE}) for driving the power semiconductor component (1) as a function of the capacitor voltage (U_{C}) present at the input end.

5. Electrical circuit arrangement according to one of Claims 2 to 4,
**characterized in that** the circuit section (6) has an input/output voltage characteristic which has at the input end a lower voltage limit value (U_{C0}) below which the output voltage (U_{GE}) is less than or equal to the capacitor voltage (U_{C}) at the input end, preferably equal to zero, and has at the input end an upper voltage limit value (U_{C1}) above which the output voltage (U_{GE}) is greater than or equal to, preferably equal to, the capacitor voltage (U_{C}) at the input end.

6. Electrical circuit arrangement according to Claim 5, **characterized in that**, when the upper voltage limit value (U_{C1}) is exceeded, the output voltage (U_{GE}) is connected with a time delay.

7. Electrical circuit arrangement according to one of Claims 1 to 6,
**characterized in that** the controllable voltage source (8) is constructed in such a manner that the output voltage (U_{S}) of the controllable voltage source (8) exhibits a rectangular periodic variation with adjustable voltage amplitude.

8. Electrical circuit arrangement according to one of Claims 1 to 7,
**characterized in that** the amplitude and/or the frequency and/or the duty ratio of the rectangular periodic output voltage (U_{S}) of the controllable voltage source (8) is determined by the control signal (A).

9. Electrical circuit arrangement according to one of Claims 1 to 8,
**characterized in that** the on-period Tₑ of the power semiconductor component (1) depends on the magnitude of the output voltage (U_{S}) of the controllable voltage source (8) which is present across the semiconductor gate (9) during the non-conductive state of the power semiconductor component (1).

## Revendications

1. Agencement de circuit électrique destiné à piloter des composants à semi-conducteurs de puissance (1) de commutation à potentiel de tension élevé comprenant un signal de réglage (A) prédéfinissant une information de commutation pour le composant à semi-conducteurs de puissance (1) et une tension de sortie (U_{GE}) commandant directement le composant à semi-conducteurs de puissance (1), une soupape à semi-conducteurs (9) non contrôlable servant à la transmission d'une énergie de commutation, la soupape à semi-conducteurs (9) non contrôlable étant réalisée sous forme de composant avec une rigidité élevée pour la transmission de l'information de commutation,
**caractérisé en ce que**
le signal de réglage (A) détermine la courbe d'une tension de sortie (U_{S}) d'une source de tension (8) contrôlable, qui est montée en série avec la soupape à semi-conducteurs (9) polarisée dans le sens de passage et non contrôlable et un condensateur (7), en particulier un agencement de condensateur (7, 11, 12).

2. Agencement de circuit électrique selon la revendication 1,
**caractérisé en ce qu'**une partie de circuit (6) est montée avec les points de branchement (a) et (b) parallèlement au condensateur (7) et est alimentée par une tension (U_{C}) s'établissant au-dessus du condensateur (7), laquelle met à disposition l'information de commutation et l'énergie de commutation.

3. Agencement de circuit électrique selon la revendication 1 ou 2,
**caractérisé en ce que** l'agencement de condensateur (7, 11, 12) comprend un circuit parallèle du condensateur (7) stockant l'information de commutation avec un montage en série d'un second condensateur (11) stockant l'énergie de commutation et une seconde soupape à semi-conducteurs (12) non contrôlable à faible rigidité, la partie de circuit (6) présentant un troisième point de branchement (c), qui est relié au potentiel de tension situé entre la seconde soupape à semi-conducteurs (12) non contrôlable et le second condensateur (11).

4. Agencement de circuit électrique selon la revendication 2 ou 3,
**caractérisé en ce que** la partie de circuit (6) génère une tension de sortie (U_{GE}) pour le pilotage du composant à semi-conducteurs de puissance (1) en fonction de la tension du condensateur (U_{C}) s'appliquant côté entrée.

5. Agencement de circuit électrique selon l'une quelconque des revendications 2 à 4,
**caractérisé en ce que** la partie de circuit (6) présente une courbe caractéristique de tension d'entrée et de sortie, qui présente côté entrée une valeur limite de tension inférieure (UC₀), au-dessous de laquelle la tension de sortie (U_{GE}) est inférieure ou égale à la tension du condensateur (U_{C}) côté entrée, de préférence égale à zéro, et côté entrée une valeur limite de tension supérieure (U_{C1}) au-dessus de laquelle la tension de sortie (U_{GE}) est supérieure ou égale, de préférence égale, à la tension du condensateur (U_{C}) côté entrée.

6. Agencement de circuit électrique selon la revendication 5,
**caractérisé en ce que**, en cas de dépassement de la valeur limite de tension supérieure (U_{C1}), la tension de sortie (U_{GE}) est appliquée avec une temporisation.

7. Agencement de circuit électrique selon l'une quelconque des revendications 1 à 6,
**caractérisé en ce que** la source de tension (8) contrôlable est conçue de telle sorte que la tension de sortie (U_{S}) de la source de tension (8) contrôlable présente une courbe périodique rectangulaire avec amplitude de tension réglable.

8. Agencement de circuit électrique selon l'une quelconque des revendications 1 à 7,
**caractérisé en ce que** l'amplitude et/ou la fréquence et/ou le taux d'impulsions de la tension de sortie (U_{S}), rectangulaire et s'appliquant périodiquement, de la source de tension (8) contrôlable est déterminé(e) par le signal de réglage (A).

9. Agencement de circuit électrique selon l'une quelconque des revendications 1 à 8,
**caractérisé en ce que** la durée d'enclenchement Tₑ du composant à semi-conducteurs de puissance (1) dépend de la grandeur de la tension de sortie (U_{S}) de la source de tension (8) contrôlable, qui s'applique sur la soupape à semi-conducteurs (9) pendant l'état non conducteur du composant à semi-conducteurs de puissance (1).
